# EUROPÄISCHE PATENTSCHRIFT

(11) **EP 1 982 362 B1**
(45) Veröffentlichungstag und Bekanntmachung des Hinweises auf die Patenterteilung: **08.03.2017**
(21) Anmeldenummer: 07711334.8
(22) Anmeldetag: 11.01.2007
(51) Int. Cl.: H01L 51/52

(54) **ORGANISCHES OPTOELEKTRONISCHES BAUELEMENT**
ORGANIC OPTOELECTRONIC COMPONENT
COMPOSANT OPTOÉLECTRONIQUE ORGANIQUE

(30) Priorität: 11.01.2006 EP 06000436
(43) Veröffentlichungstag der Anmeldung: 22.10.2008
(73) Patentinhaber: Novaled GmbH, 01307 Dresden (DE)
(72) Erfinder: SCHWARTZ, Gregor, 01159 Dresden (DE); HARADA, Kentaro, 01307 Dresden (DE); WALZER, Karsten, 01099 Dresden (DE); PFEIFFER, Dr. Martin, 01129 Dresden (DE); LEO, Karl, 01219 Dresden (DE); WERNER, Ansgar, 01277 Dresden (DE)
(74) Vertreter: Bittner, Thomas L.
(86) Internationale Anmeldenummer: PCT/EP2007/000208
(87) Internationale Veröffentlichungsnummer: WO 2007/082673

(56) Entgegenhaltungen:
- WO-A-2004/086462
- US-A- 5 885 498
- US-A1- 2002 180 372
- US-A1- 2004 021 434
- US-A1- 2005 118 745
- US-A1- 2006 175 960
- US-B1- 6 356 032
- HONG IL-HWA ET AL: "Effective hole injection of organic light-emitting diodes by introducing buckminsterfullerene on the indium tin oxide anode" APPLIED PHYSICS LETTERS, AIP, AMERICAN INSTITUTE OF PHYSICS, MELVILLE, NY, US, Bd. 87, Nr. 6, 1. August 2005 (2005-08-01), Seiten 63502-63502, XP012077425 ISSN: 0003-6951

## Beschreibung

Die Erfindung betrifft ein organisches optoelektronisches Bauelement, insbesondere eine organische lichtemittierende Diode.

### Hintergrund der Erfindung

Elektrolumineszenz organischer Materialien ist seit ihrer ersten Beobachtung 1953 (Bemanose et al., J. Chem. Phys. 1953, 50, 65) zu einem intensiv bearbeiteten Forschungsgebiet geworden. Die bekannten Vorteile organischer Materialien für die Lichterzeugung wie zum Beispiel geringe Reabsorption, hohe Quantenausbeuten oder auch die Möglichkeit, durch relativ einfache Variation der Molekülstruktur das Emissionsspektrum anzupassen, konnten in den letzten Jahren durch beständige Entwicklung in der Materialforschung und Umsetzung neuer Konzepte zum effektiven Injizieren und Transportieren der Ladungsträger in die aktive Emissionsschicht eines organischen Leuchtelements ausgenutzt werden. Erste Anzeigeeinrichtungen, welche auf solchen so genannten organischen Leuchtdioden basieren, haben bereits den Weg auf den Markt gefunden und organische Leuchtdioden werden in Zukunft als Konzept neben Flüssigkristallanzeigen und Anzeigen aus anorganischen Leuchtdioden fest etabliert sein. Ein weiterer Markt, welcher den organischen Leuchtdioden aufgrund ihrer speziellen Eigenschaft, Licht großflächig und homogen in den Halbraum emittieren zu können, offen steht, ist das Gebiet der Beleuchtung.

Häufig wird bei organischen Leuchtdioden Licht durch ein transparentes Substrat emittiert (sog. bottom-emission Struktur). In einigen Fällen kann es zur Verbesserung der Leistungsparameter des Bauelements oder zur Reduzierung der Produktionskosten vorteilhaft sein, nicht-transparente Substrate zu verwenden. In diesem Fall wird das Licht durch die Deckelektrode der Schichtstruktur emittiert (sog. "top-emission" Struktur). Für diesen Zweck wird eine genügend transparente Deckelektrode benötigt. Beide Ansätze können auch kombiniert werden um transparente organische Leuchtdioden zu erhalten.

Transparente Deckelektroden werden herkömmlich aus transparenten leitfähigen Metalloxiden, insbesondere Indium-Zinn-Oxid (ITO) gefertigt. Dieser Ansatz birgt einige Schwierigkeiten, die die Einsatzfähigkeit dieser Lösung beeinträchtigen. Die Leitfähigkeit der ITO Schicht ist gering, so dass es bei großflächigen Strukturen aufgrund des Schichtwiderstandes zu einem Spannungsabfall in der Schicht und damit zu einer lateral inhomogenen Lichtemission kommt. Weiterhin wird die Schicht mittels eines Sputterprozesses aufgebracht. Die darunterliegenden organischen Schichten sind in der Regel sehr anfällig gegenüber bei diesem Prozeß entstehenden, reaktiven Ionen. Nachteilige Effekte für die Leistungsparameter des Bauelementes und die Lebensdauer können nur zum Teil mittels Einfügen von Pufferschichten kompensiert werden. In der Regel sind die Metalloxide für die Injektion von Löchern, nämlich zur Verwendung als Anode gut geeignet, während die Injektion von Elektronen Probleme bereitet. Schließlich bedeutet der hohe Anteil von Indium in der ITO-Schicht einen erheblichen Kostenfaktor.

Alternativ können diese Metallschichten als transparente Deckelektroden verwendet werden. Dünne Metallschichten wie beispielsweise 15nm Silber weisen nur eine geringe Absorption auf und sind genügend transparent. Nachteilig ist die Schwierigkeit, solche dünnen Schichten kontrolliert abzuscheiden. Weiterhin sind diese Schichten mechanisch nicht stabil und führen häufig zu einem vorzeitigen Ausfall des Bauelementes aufgrund eines Risses in der Deckelektrode. Schließlich führt die hohe Reflektivität der Deckelektrode zu Schwierigkeiten, die Interferenzeffekte in dem Bauelement zu beherrschen. Die hohe Güte der entstehenden Mikrokavität führt dazu, dass ein enger Wellenlängenbereich des entstehenden Lichts bevorzugt wird, während andere Bereiche unterdrückt werden. Dies führt insbesondere bei der Emission von weißem Licht dazu, dass das intendierte Emissionsspektrum verfälscht wird. Damit kann diese Bauelement für einige Einsatzbereiche, beispielsweise als Beleuchtungselement oder als Hintergrundbeleuchtungselement eines LCD Displays, nicht eingesetzt werden.

Schließlich wurde in dem Dokument US 2004/0021434 A1 vorgeschlagen, dass eine Deckelektrode mit Durchbrüchen versehen wird. Es hat sich gezeigt, dass solche Durchbrüche den Leuchteindruck des Bauelementes nachteilig beeinflussen, da in ihrem Bereich nichtleuchtende Abschnitte auftreten.

Auch im Dokument US 2005/0118745 A1 ist ein lichtemittierendes Bauelement offenbart, bei dem die Deckelektrode Durchbrüche aufweist. Es werden Ausführungsformen beschrieben, bei denen unterhalb der Deckelektrode eine transparente leitende Schicht angeordnet ist, die mittels einer transparenten leitenden Filmschicht von einem Stapel organischer Schichten getrennt ist, welcher die lichtemittierende Schicht umfasst.

Aus dem Dokument US 2002/0180372 A1 ist ein lumineszierendes Bauelement bekannt, bei der in einer Ausgestaltung die Anode wenigstens einen Schlitz aufweist und zwischen der Anode und der Kathode eine organische Schicht mit einer Löchertransportschicht gebildet ist.

Aus dem Dokument Hong Il-Hwa et al. (Appl. Phys. Lett., 87(2005)63502) sind organische lichtemittierende Dioden mit Fulleren bekannt.

Das Dokument US 2006/0175960 A1 offenbart ein organisches Licht emittierendes Bauelement. Auf einem Substrat sind eine gitterartige Anode, eine Löchertransportschicht, eine aktive Licht emittierende Schicht, eine Elektronentransportschicht und eine gitterartige Kathode gebildet.

Ein weiteres organisches Licht emittierendes Bauelement ist aus dem Dokument US 5,885,498 bekannt.

### Zusammenfassung der Erfindung

Aufgabe der Erfindung ist es, ein organisches optoelektronisches Bauelement mit einer Deckelektrode mit Durchbrüchen zu schaffen, bei dem Durchbrüche in der Deckelektrode den Leuchteindruck des Bauelementes nicht störend beeinflussen.

Diese Aufgabe wird erfindungsgemäß durch ein organisches optoelektronisches Bauelement nach dem unabhängigen Anspruch 1 gelöst.

Mit Hilfe der organischen Stromverteilungsschicht wird erreicht, dass an der Deckelektrode injizierte, elektrische Ladungsträger in Form von Löchern oder Elektronen auch zu den Abschnitten des lichtemittierenden Bereiches in der Anordnung organischer Schichten gelangen, welcher sich unterhalb der Durchbrüche der Deckelektrode befinden, die auch als Ausnehmungen bezeichnet werden können. Auf diese Weise wird auch in diesen Abschnitten des lichtemittierenden Bereiches Licht mittels Rekombination von Ladungsträgern erzeugt, so dass auch diese Abschnitte zur Lichterzeugung beitragen. Beim Stand der Technik findet diese Licht erzeugende Rekombination im wesentlichen im Überlappungsbereich der Elektroden und nicht in dem von den Durchbrüchen erfassten Bereich statt. Die Ausbildung der organischen Stromverteilungsschicht auch in den Bereich der Durchbrüche hinein bedeutet, dass sich die organische Stromverteilungsschicht überlappend mit den Durchbrüchen erstreckt, wobei die organische Stromverteilungsschicht sich sowohl in den Durchbrüchen selbst als auch oberhalb und unterhalb der Durchbrüche oder in einer beliebigen Kombination dieser Teilbereiche erstrecken kann. Bevorzugt ist die Überlappung zwischen der organischen Stromverteilungsschicht und den auch als Öffnungen bezeichneten Durchbrüchen aus einer Sicht auf das Bauelement von oben vollständig.

Die Durchbrüche in der Deckelektrode können so ausgeführt sein, dass die Deckelektrode mit mehreren Stegen gebildet ist, die ihrerseits runde oder eckige Durchbrüche teilweise oder vollständig umgreifen. Auch eine Deckelektrode mit mehreren streifenartig gebildeten Elektrodenelementen kann vorgesehen sein. In einer zweckmäßigen Ausgestaltung ist die Deckelektrode als eine für das in dem lichtemittierenden Bereich erzeugte Licht nicht-transparente Elektrode gebildet. Dieses ermöglicht die Verwendung von dicken Metallschichten für die Deckelektrode mit einer Schichtdicke von 100 nm oder mehr, wodurch die Stabilität des Bauelementes optimiert ist. Den verschiedenen Bauformen für organische optoelektronische Bauelemente entsprechend kann die Deckelektrode als eine Anode oder eine Kathode gebildet sein.

Bevorzugt ist die organische Stromverteilungsschicht aus einem thermisch sublimierbaren, organischen Material gebildet, welches mittels Vakuumverdampfung abgeschieden werden kann. Auf diese Weise ist zur Ausbildung der organischen Stromverteilungsschicht bei der Bauelementeherstellung die häufig zur Bildung organischer Schichten genutzte Technologie des Abscheidens mittels Vakuumverdampfung nutzbar.

Eine bevorzugte Weiterbildung der Erfindung sieht vor, dass die organische Stromverteilungsschicht in Berührungskontakt mit der Deckelektrode gebildet ist. Bei dieser Ausführungsform ist die organische Stromverteilungsschicht in direktem Kontakt mit der Deckelektrode. Alternativ kann vorgesehen sein, dass die organische Stromverteilungsschicht über einen elektrisch leitenden Materialabschnitt mit der Deckelektrode in elektrischem Kontakt ist. Ein Berührungskontakt zwischen der organischen Stromverteilungsschicht und der Deckelektrode entsteht bei der Herstellung des optoelektronischen Bauelementes beispielsweise dadurch, dass das Material für die organische Stromverteilungsschicht und das Material für die Deckelektrode oder umgekehrt direkt aufeinander abgeschieden werden.

Bei einer zweckmäßigen Ausgestaltung der Erfindung kann vorgesehen sein, dass die organische Stromverteilungsschicht mit einer elektrischen Leitfähigkeit von wenigstens 0.05 S/cm gebildet ist, weiter bevorzugt mit einer elektrischen Leitfähigkeit von wenigstens 1 S/cm. Als alternative Messgröße kann der elektrische Schichtwiderstand der Stromverteilungsschicht betrachtet werden. Er ist zweckmäßig kleiner als 10⁸ Ohm/Quadrat, bevorzugt kleiner als 10⁶ Ohm/Quadrat und weiter bevorzugt kleiner als 10⁵ Ohm/Quadrat. Mit Hilfe der vorgesehenen elektrischen Leitfähigkeit wird eine optimierte Funktionalität der Stromverteilungsschicht gewährleistet, so dass sich elektrischer Strom in Form eines Transports von elektrischen Ladungsträgern in der organischen Stromverteilungsschicht optimal in lateraler Richtung, d. h. in Richtung der Ausdehnung der Stromverteilungsschicht ausbreiten kann. Wenn das Bauelement mit seiner Schichtstruktur im Schnitt betrachtet wird, kann die erreichte Stromverteilung auch als Querleitung von elektrischen Ladungsträgern betrachtet werden.

Bevorzugt wird zur Ausbildung der organischen Stromverteilungsschicht ein Material verwendet wendet, mit dem eine hohe Beweglichkeit für wenigstens eine Art von elektrischen Ladungsträgern bereitgestellt ist. Die Beweglichkeit ist vorteilhaft größer als 10⁻⁴cm²/Vs, bevorzugt größer als 10⁻²cm²/Vs und weiter bevorzugt größer als 10⁻¹cm²/Vs.

Eine vorteilhafte Ausuhrungsform der Erfindung sieht vor, dass eine minimale Abmessung der Durchbrüche wenigstens so groß ist wie eine Gesamthöhe der Anordnung organischer Schichten.

Bevorzugt sieht eine Fortbildung der Erfindung vor, dass die organische Stromverteilungsschicht als eine elektrische Ladungsträger in Form von Löchern in Richtung der Schichtausdehnung transportierende Schicht gebildet ist, wenn die Deckelektrode eine Anode ist.

Bei einer vorteilhaften Ausgestaltung der Erfindung kann vorgesehen sein, dass die organische Stromverteilungsschicht als eine elektrische Ladungsträger in Form von Elektronen in Richtung der Schichtausdehnung transportierende Schicht gebildet ist, wenn die Deckelektrode eine Kathode ist.

Es ist vorgesehen, dass die organische Stromverteilungsschicht als eine dotierte organische Schicht mit einer die elektrische Leitfähigkeit erhöhenden Dotierung gebildet ist. Beim Ausbilden einer dotierten organischen Schicht werden ein oder mehrere Dotierungsmaterialien in ein organisches Matrixmaterial eingelagert, bei dem es sich um ein organisches Halbleitermaterial handelt. Eine Schicht wird als p-dotierte organische Schicht bezeichnet, wenn das organische Matrixmaterial Dotanden in Form von Akzeptoren enthält. Eine dotierte Schicht wird als n-dotierte organische Schicht bezeichnet, wenn die eingelagerten Dotanden für das organische Matrixmaterial Donatoren bilden. Eine elektrische Dotierung im Sinne der vorliegenden Anmeldung entsteht dadurch, dass das eine oder die mehreren eingelagerten Dotierungsmaterialien eine Redoxreaktion mit dem Matrixmaterial ausführen, wodurch es zu einem wenigstens teilweisen Ladungstransfer zwischen dem einen oder den mehreren Dotierungsmatarialien einerseits und dem Matrixmaterial andererseits kommt, d. h. eine Übertragung von elektrischen Ladungen zwischen den Materialien findet statt. Auf diese Weise werden (zusätzliche) freie Ladungsträger in der Schicht gebildet, welche ihrerseits die elektrische Leitfähigkeit der Schicht erhöhen. Es entsteht in dem Matrixmaterial eine höhere Dichte von Ladungsträgern im Vergleich zum undotierten Material. Es besteht der folgende physikalische Zusammenhanges für die elektrische Leitfähigkeit: Ladungsträgerdichte x Beweglichkeit der Ladungsträger = elektrische Leitfähigkeit. Der mittels der Redoxreaktion gebildete Teil der Ladungsträger in dem Matrixmaterial muss nicht erst aus einer Elektrode injiziert werden, vielmehr stehen solche Ladungsträger infolge der elektrischen Dotierung schon in der Schicht zur Verfügung.

Eine bevorzugte Weiterbildung der Erfindung sieht vor, dass die organische Stromverteilungsschicht als eine Fullerenschicht gebildet ist.

Bei einer zweckmäßigen Ausgestaltung der Erfindung kann vorgesehen sein, dass die organische Stromverteilungsschicht in Verbindung mit einem pn-Übergang gebildet ist. Der pn-Übergang kann in der Stromverteilungsschicht gebildet sein. Alternativ grenzt die Stromverteilungsschicht an den pn-Übergang oder bildet einen Teil hiervon. Für den Fall, dass die Deckelektrode als eine Anode gebildet ist, die ihrerseits mit einer organischen Schicht in elektrischem Kontakt ist, welche elektrische Ladungsträger in Form von Elektronen effizient in Richtung der Schichtausdehnung transportiert, wird mit dem pn-Übergang eine effiziente Bereitstellung von elektrischen Ladungsträgern für den lichtemittierenden Bereich in Form von Löchern erreicht. Im Bereich des pn-Überganges werden die effizient transportierten elektrischen Ladungsträger in Form von Elektronen in elektrische Ladungsträger in Form von Löcher umgewandelt. In analoger Weise werden elektrische Ladungsträger in Form von Elektronen an einem pn-Übergang in der organischen Stromverteilungsschicht bereitgestellt, wenn die Deckelektrode eine Kathode ist und diese in elektrischem Kontakt mit einer Löcher in Richtung der Schichtausdehnung transportierenden Schicht ist.

Die organische Stromverteilungsschicht kann auch teilweise auf einer von der Anordnung organischer Schichten abgewandten Seite der Deckelektrode gebildet sein. Bei dieser Ausgestaltung wird die organische Stromverteilungsschicht beim Herstellen des Bauelementes zum Beispiel nach dem Abscheiden des Materials für die Deckelektrode aufgebracht. Das Material für die organische Stromverteilungsschicht kann in diesem Fall teilweise direkt auf das Material der Deckelektrode aufgebracht werden.

Vorzugsweise beträgt eine minimale laterale Dimension der Deckelektrode, also eine kleinste Abmessung der flächigen Ausdehnung der Abschnitte der Deckelektrode, wenigstens etwa 1 µm, bevorzugt wenigstens etwa 10 µm. In diesem Fall kann die Deckelektrode leicht in einem Verdampfungsschritt im Vakuum mit Hilfe von Schattenmasken hergestellt werden. Im Falle das die Deckelektrode als Gitter ausgebildet ist, kann eine charakteristische laterale Dimension der Deckelektrode beispielsweise die Breite eines Steges des Gitters sein.

In einer zweckmäßigen Ausgestaltung kann vorgesehen sein, dass ein relativer Anteil einer Gesamtfläche der Durchbrüche, die sich aus der Summe der Teilflächen der einzelnen Durchbrüche ergibt, an der Gesamtfläche der Deckelektrode wenigstens etwa 50 %, bevorzugt wenigstens etwa 80 % und weiter bevorzugt wenigstens etwa 90 % beträgt. Auf diese Weise wird gewährleistet, dass die Fläche der Öffnungen / Durchbrüche genügend groß ist, um eine effektive Extraktion des Lichtes zu gewährleisten.

Die organische Stromverteilungsschicht ist mit einer Schicht aus einem Ladungsträgertransportmaterial und einer hieran grenzenden Schicht aus einem Dotandenmaterial gebildet. Durch eine chemische Reaktion an der Grenzfläche der beiden Schichten entsteht eine hochleitfähige Grenzschicht. Diese Grenzschicht kann man sich als eine dotierte Grenzfläche vorstellen. Beispiele für Schichtkombinationen aus einem Ladungsträgertransportmaterial und einem Dotandenmaterial sind: Fullerene C60 und WPW, Fullerene C60 und Alkalimetalle with Cs oder Kalium, Zink Phthalocyanine und F4TCNQ, PTCTA und Jod, BEDT-TTF und Jod, TTF und TCNQ.

Die organische Stromverteilungsschicht wird zweckmäßig mittels Materialabscheidung im Vakuum gebildet, beispielsweise mittels Abscheiden im Hochvakuum. In einer Ausgestaltung werden Fullerene verdampft. Im Fall einer dotierten Schicht werden die Fullerene und der organische Dotand gleichzeitig verdampft. Hierdurch fügt sich das Aufbringen ohne Mehraufwand in den Produktionsprozess eines organischen Bauelementes ein. Mögliche Inkompatibilitäten aufgrund anderer Abscheidungsverfahren wie Zerstäuben (Sputtern, Effekte der reaktiven Ionen) oder Abscheiden von Lösungen oder Pasten (Effekte des Lösungsmittels) werden so vermieden.

Eine Weiterentwicklung der transparenten organischen Leuchtdiode sind gestapelte transparente Leuchtdioden (siehe zum Beispiel Gu et al. J. Appl. Phys. 1999, 86, 4067). Hierbei wird eine Anzahl transparenter Leuchtdioden sequentiell auf ein Substrat gestapelt aufgebracht, wobei jeweils zwei aufeinander folgende Leuchtdioden eine transparente Elektrode gemeinsam haben. Um die Leuchtdioden des Stapels einzeln ansteuern zu können, werden transparente Elektroden seitlich herausgeführt und kontaktiert. Dazu ist eine hohe laterale Leitfähigkeit der Elektroden notwendig, weshalb dazu üblicherweise ITO verwendet wird. Dies führt zu den gleichen bereits genannten Problemen wie bei den transparenten Leuchtdioden. Es versteht sich, dass die erfindungsgemäße Struktur in solchen Konfiguration ebenfalls vorteilhaft ist.

Die Kombination von Deckelektrode mit Durchbrüchen und organischer Stromverteilungsschicht kann in beliebigen optoelektronischen Bauelementen eingesetzt werden. Beispielsweise ist der Einsatz für eine organische Solarzelle vorteilhaft, deren lichtdurchlässige Elektrode als Deckelektrode gebildet ist. Die mit hoher elektrischer Leitfähigkeit in Richtung der Schichtausbreitung ausgestattete, organische Stromverteilungsschicht befindet sich dann auf der der Deckelektrode zugewandten Seite der aktiven, Licht in Ladungsträger transferierenden Schicht der Solarzelle.

### Beschreibung von bevorzugten Ausführungsbeispielen der Erfindung

Die Erfindung wird im Folgenden anhand von bevorzugten Ausführungsbeispielen unter Bezugnahme auf Figuren einer Zeichnung näher erläutert. Hierbei zeigen:
- Fig. 1: eine schematische Darstellung eines Schichtaufbaus eines organischen optoelektronischen Bauelementes,
- Fig. 2: eine schematische Darstellung eines organischen optoelektronischen Bauelementes von oben,
- Fig. 3: eine grafische Darstellung der Stromdichte und der Helligkeit in Abhängigkeit von der Spannung für ein organisches optoelektronisches Bauelement nach Beispiel 1,
- Fig. 4: eine grafische Darstellung der externen Quanteneffizienz in Abhängigkeit von der Helligkeit für das organische optoelektronische Bauelement nach Beispiel 1,
- Fig. 5: eine grafische Darstellung der Stromdichte und der Helligkeit in Abhängigkeit von der Spannung für ein organisches optoelektronisches Bauelement nach einem Beispiel 2,
- Fig. 6: eine grafische Darstellung der externen Quanteneffizienz in Abhängigkeit von der Helligkeit für das organische optoelektronische Bauelement nach Beispiel 2 und
- Fig. 7: eine schematische Darstellung einer Anordnung gestapelter organischer Leuchtdioden.

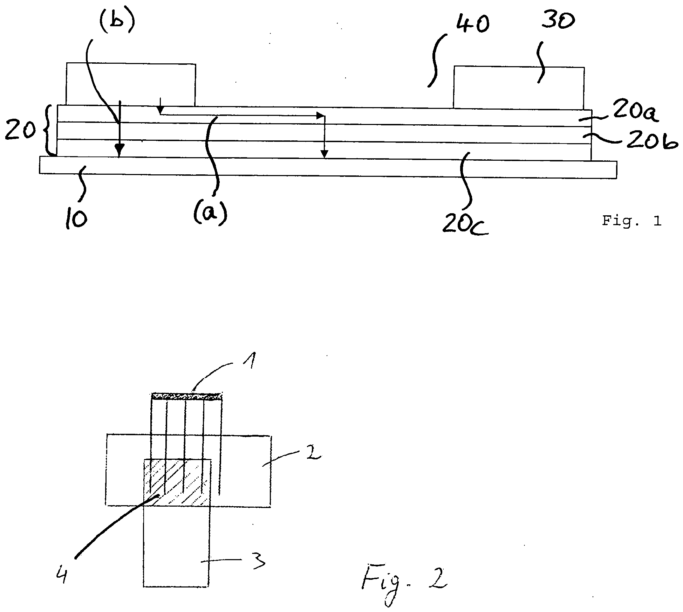

Fig. 1 zeigt eine schematische Darstellung eines organischen optoelektronischen Bauelementes mit einer organischen Stromverteilungsschicht 20a in einer Anordnung organischer Schichten 20, die zwischen einer Grundelektrode 10 und einer mit einem Durchbruch 40 versehenen Deckelektrode 30 angeordnet ist.

Die organische Stromverteilungsschicht 20a verfügt über eine elektrische Leitfähigkeit für elektrische Ladungsträger in Form von Löchern oder Elektronen, so dass sich diese in Richtung der Schichtausbreitung zu einem lichtemittierenden Bereich 20b hin auch in den Bereich des Durchbruchs 40 verteilen können, was in Fig. 1 mittels eine Pfeilpfades (a) gezeigt ist. Unterhalb des lichtemittierenden Bereiches 20b ist eine Ladungsträgertransportschicht 20c gebildet, mit der zu dem lichtemittierenden Bereich 20b elektrische Ladungsträger geleitet werden, die hinsichtlich ihrer Polarität entgegengesetzt zu den elektrischen Ladungsträgern sind, die dem lichtemittierenden Bereich 20b von oben zugeführt werden.

Mit Hilfe der organischen Stromverteilungsschicht 20a wird erreicht, dass der elektrische Widerstand eines in Fig. 1 im wesentlichen vertikal verlaufenden Strompfades (b) nur unwesentlich geringer ist als der elektrische Widerstand des Strompfades, welcher in Fig. 1 mit (a) bezeichnet ist. Die Erzeugung von Licht findet deshalb im wesentlichen unterhalb des in der Deckelektrode 30 gebildeten Durchbruches 40 statt.

Die Erfindung wird im Folgenden anhand von weiteren Beispielen näher erläutert. Hierbei beschreiben die nm-Angaben die im jeweiligen Ausführungsbeispiel gebildeten Schichtdicken für die mittels Aufdampfen im Vakuum abgeschiedenen Materialien, die thermisch sublimierbar sind.

In einem Beispiel 1 weist ein organisches optoelektronisches Bauelement den folgenden Schichtaufbau auf, welcher mittels Aufdampfen in einem Hochvakuum hergestellt ist:
1. Glassubstrat
2. Silberelektrode 50nm
3. 95nm MeO-TPD dotiert mit 4 mol% F₄-TCNQ
6. 10nm Spiro-TAD
7. 20nm BAlq dotiert mit 20 Gewichts-% Ir(piq)₃
8. 10nm BPhen
9. 65nm Fullerenschicht dotiert mit WPW (10w%)
10. Aluminiumkathode, mit beabstandeten Streifenelementen ausgeführt, zwischen denen Durchbrüche gebildet sind (Abstände zwischen den Streifenelementen 450µm, Breite der Streifenelemente 50µm, Dicke der Streifenelemente 100nm)

Zur Veranschaulichung zeigt Fig. 2 eine Draufsicht dieser Anordnung. Die Anordnung emittiert bei angelegter Spannung (Pluspol an die Silberelektrode 3, Minuspol an die Aluminiumkathode 1) Licht durch die Deckelektrode. Die leuchtende Fläche 4, welche schraffiert ist, ist durch die laterale Überlappung zwischen der Silberanode 1 und einer dotierter Fullerenschicht 2 bestimmt. Ist die Leitfähigkeit der dotierten Fullerenschicht 2 größer als 0.5 S/cm, erscheint die Helligkeit der leuchtenden Fläche 4 dem Betrachter mit bloßem Auge homogen. Die Beweglichkeit für Elektronen in einer Schicht aus Fullerene C60 beträgt mehr als 0.1 cm²/Vs.

In einer Ausführung des Beispiels wurde durch Verwendung einer anderen n-dotierten Schicht, nämlich C₆₀ dotiert mit 2 mol% [Ru(t-butyl-trpy)₂]⁰), eine geringere Leitfähigkeit von kleiner 0.5 S/cm erzielt. In dieser Konfiguration ist ein leichter Abfall der Helligkeit zwischen Stegen der Aluminiumkathode 1 mit bloßem Auge sichtbar.

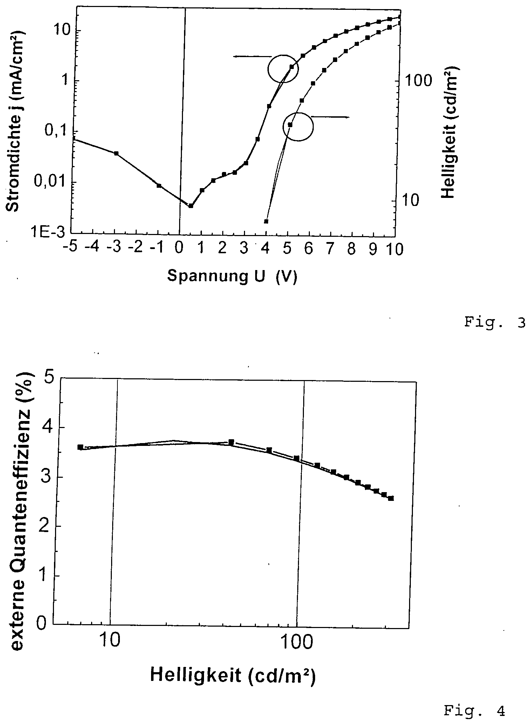

Fig. 3 und 4 zeigen Kennlinien des Bauelementes gemäß Beispiel 1.

Als Vergleichsbeispiel wurde ein organisches optoelektronisches Bauelement mit folgendem Schichtaufbau hergestellt:
1. Glassubstrat
2. Silberelektrode 50nm oder ITO 90nm
3. 95nm MeO-TPD dotiert mit 4 mol% F₄-TCNQ
6. 10nm Spiro-TAD
7. 20nm BAlq dotiert mit 20 Gewichts-% Ir(piq)₃
8. 10nm BPhen
9. 65nm Alq
10. 1nm LiF
11. Aluminiumkathode, als Streifen ausgeführt (Abstände 450µm, Breiten 50µm, Dicke 100nm)

In diesem Vergleichsbeispiel ist die Stromverteilungsschicht durch eine herkömmliche nichtleitfähige Elektronentransportschicht aus Alq ersetzt. Zu Verbesserung Ladungsträgerinjektion ist eine dünne Schicht aus LiF gebildet. Im Falle, dass die Anode aus Silber gebildet ist, ist etwas Lichtemission an den Rändern der Streifen der Aluminiumkathode 1 zu erkennen. Der Unterschied zu dem Beispiel 1 ist deutlich zu erkennen. Im Falle, dass eine transparente Grundelektrode aus ITO verwendet wird, wird sichtbar, dass fast alle Lichtemission von der Fläche erfolgt, die durch die Überlappung der Grund- und Deckelektrode gebildet wird.

In einem Beispiel 2 weist ein organisches optoelektronisches Bauelement, nämlich eine transparente organische lichtemittierende Diode, den folgenden Schichtaufbau auf:
1. Glassubstrat
2. 90nm ITO
3. 95nm MeO-TPD dotiert mit 4 mol% F₄-TCNQ
6. 10nm Spiro-TAD
7. 20nm BAlq dotiert mit 20 Gewichts-% Ir(piq)₃
8. 10nm BPhen
9. 65nm n-dotierte Fullerenschicht
10. Aluminiumkathode, als Streifen ausgeführt (Abstände 450µm, Breiten 50µm, Dicke 100nm)

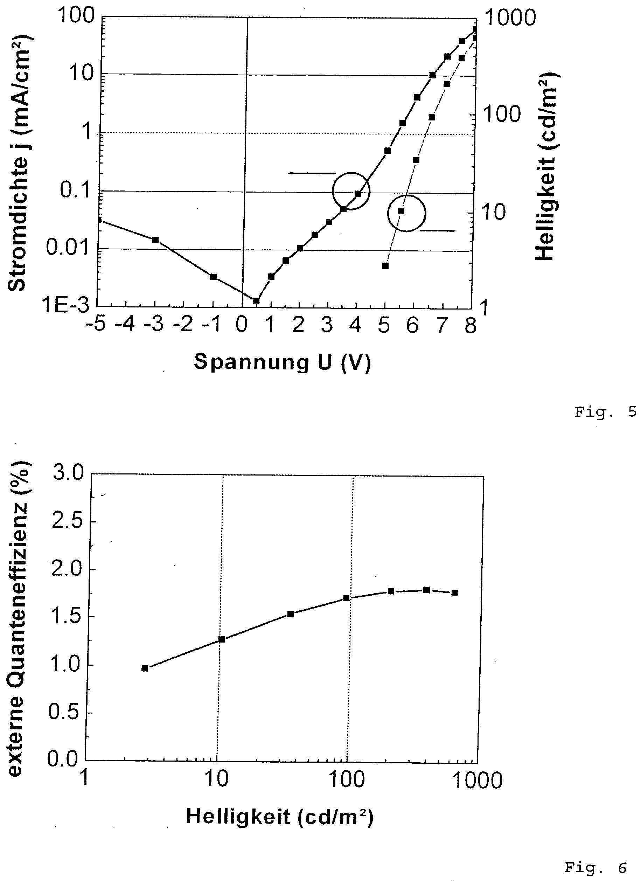

In dieser Anordnung wird BPhen als Löcher- und Exzitonenblockschicht verwendet. Mit etwa 3 eV hat BPhen eine um etwa 0.9 eV kleinere Elektronenaffinität als C60, was sich in einer entsprechend hohen Barriere für Elektronen bemerkbar machen sollte. Dennoch zeigt dieses Bauelement überraschenderweise sehr gute Parameter, wie einige Kenndaten in Fig. 5 und 6 zeigen.

In einem Beispiel 3 weist ein organisches optoelektronisches Bauelement den folgenden Schichtaufbau auf:
1. Glassubstrat
2. 90nm ITO
3. 95nm MeO-TPD dotiert mit 4 mol% F₄-TCNQ
6. 10nm Spiro-TAD
7. 20nm BAlq dotiert mit 20 Gewichts-% Ir(piq)₃
8. 10nm BPhen
8a. 40nm BPhen dotiert mit Cs
9. 25nm PTCDA dotiert mit Natrium
10. Aluminiumkathode, als Streifen ausgeführt (Abstände 450µm, Breiten 50µm, Dicke 100nm)

Im Beispiel 3 wird gezeigt, dass mit Natrium dotiertes PTCDA ebenfalls eine genügend hohe elektrische Leitfähigkeit aufweist, um eine nahezu homogene Verteilung der Lichtemission für die gewählte Elektrodengeometrie zu besitzen. Die elektrische Leitfähigkeit beträgt etwa 0.1 S/cm. Zur Verbesserung des Übergangs von Ladungsträgern von der Schicht aus PTCDA:Na in die angrenzende BPhen-Schicht wurde letztere ebenfalls dotiert. Die Leitfähigkeit der Schicht aus BPhen:Cs ist mit 0.000 1S/cm jedoch nicht ausreichend, um eine laterale Verteilung des Stromes allein zu gewährleisten. Dies zeigt sich dadurch, dass Licht nur in der Überlappungsfläche von Grundelektrode und Deckelektrode erzeugt wird, wenn die dotierte PTCDA-Schicht weggelassen wird.

In einem Beispiel 4 weist ein organisches optoelektronisches Bauelement den folgenden Schichtaufbau auf:
1. Glassubstrat
2. 50nm Silberkathode
3. 40nm BPhen dotiert mit Cs
6. 10nm BPhen
7. 20nm BAlq dotiert mit 20 Gewichts-% Ir(piq)₃
8. 50nm Spiro-TAD
9. 25nm Perylen dotiert mit Jod
10. Silberanode, als Streifen ausgeführt (Abstände 450µm, Breiten 50µm, Dicke 100nm)

Die dotierte Perylen-Schicht weist eine elektrische Leitfähigkeit von mehr als 5 S/cm auf. Die Beweglichkeit für Löcher in einer Perylen-Schicht ist größer als 10⁻¹ cm²/Vs. Die Lichtemission erfolgt lateral homogen. Die Deckelektrode ist als Anode ausgeführt.

In einem Beispiel 5 weist ein organisches optoelektronisches Bauelement, nämlich eine gestapelte organische Leuchtdiode mit einer Fullerenschicht als transparenter Zwischenelektrode, den folgenden Schichtaufbau auf:
1. Transparentes Glassubstrat
2. ITO
3. erste organische Leuchtdiode
4. Metallstreifen
5. dotierte Fullerenschicht
6. zweite organische Leuchtdiode
7. Aluminiumkathode

Die Stapelung kann natürlich auf mehrere Leuchtdioden erweitert werden, wobei die Metallstreifen zusammen mit der dotierten Fullerenschicht jeweils als transparente Zwischenelektrode funktionieren. Die einzelnen Leuchtdioden, welche jeweils Licht unterschiedlicher Farbe emittieren können, lassen sich separat adressieren, wenn man auch die Zwischenelektroden auf geeignete Potentiale legt. Dies wurde bereits in dem Dokument US 5,917,280 gezeigt, wo hierzu auch ein Ansteuerungsschema vorschlagen wird. Diese separate Adressierung ist sowohl für Displayanwendungen wegen der mit der Stapelung erreichbaren höheren Pixeldichte als auch für Beleuchtungszwecke wegen der Einstellbarkeit der Farbe der Lichtquelle von Vorteil.

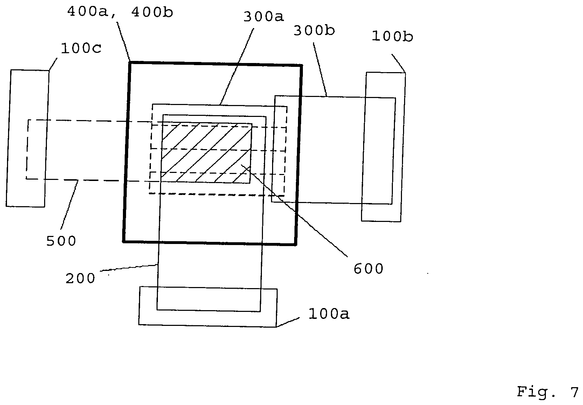

Eine besondere Herausforderung ist in dem Beispiel 5 das Herausführen der Metallstreifen aus dem Stapel und deren stabile Kontaktierung, ohne dabei Kurzschlüsse zu den anderen Elektroden zu verursachen. Dazu ist in Fig. 7 eine Anordnung gezeigt, die diese Probleme umgeht, indem Zwischenelektroden zu verschiedenen Seiten des Stapels herausgeführt werden. So werden Kurzschlüsse zwischen den einzelnen Elektroden vermieden. Hierbei werden die folgenden Bezugszeichen verwendet: 100a, 100b, 100c - Kontakte; 200 - transparente Anode, zum Beispiel aus ITO; 300a - transparente Zwischenelektrode, bestehend aus Metallstreifen und dotierter Fullerenschicht; 300b - dicke Metallschicht zur Kontaktierung der transparenten Zwischenelektrode 300a mit dem Kontakt 100b; 400a - erste organische Leuchtdiode; 400b - zweite organische Leuchtdiode; 500 - Kathode, zum Beispiel aus Aluminium und 600 (schraffiert) - Überlappbereich der Elektroden, leuchtende Fläche.

Mit der Zahl der gestapelten organischen Leuchtdioden nimmt auch die Höhe der Stufe zu, welche von den herausgeführten Elektroden überwunden werden muss, da der eigentliche Kontakt üblicherweise direkt auf dem Substrat aufgebracht ist. Da die Metallstreifen jedoch nur einige 10 Nanometer dick sein dürfen, entsteht mit zunehmender Höhe die Gefahr, dass die Streifen nicht mehr durchgängig sind, wenn sie über die Stufe führen. Dies wird in der vorgestellten Anordnung derart behoben, dass die Metallstreifen zwar aus dem Überlappungsbereich der Elektroden herausgehen, aber nicht über die darunterliegenden organischen Schichten hinaus. Darauf wird dann eine dicke Metallschicht aufgebracht, welche die Stufe überwindet und bis zum eigentlichen Kontakt führt.

Die Ausweitung auf mehr als zwei übereinander gestapelte organische Leuchtdioden ist dadurch möglich, dass die jeweils hinzukommenden Zwischenelektroden nach anderen Seiten des Stapels gemäß der vorangehenden Erläuterung herausgeführt und kontaktiert werden. Speziell für den Fall, dass mehr als vier Elektroden und Zwischenelektroden kontaktiert werden sollen, kann es vorteilhaft sein, die organischen Schichten anstatt in rechteckiger Form in mehrseitiger Form aufzubringen, um für jede zu kontaktierende Elektrode eine möglichst kurze Kantenlinie der zu überwindenden Stufe zu ermöglichen.

Nachfolgend werden die in den vorangehend beschriebenen Beispielen verwendeten organische Materialien in einer tabellarischen Übersicht gezeigt.

| | |
|---|---|
| MeO-TPD | 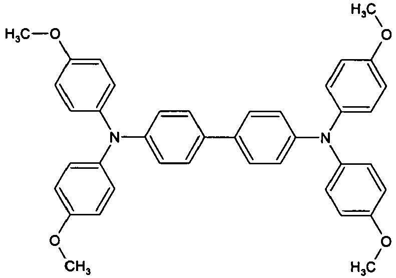 |
| N,N,N',N'-Tetrakis(4-methoxyphenyl)-benzidine | |
| Spiro-TAD | 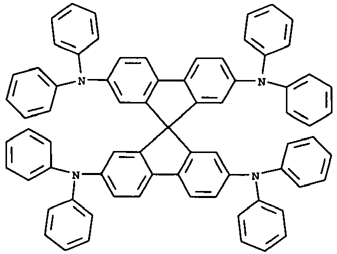 |
| 2,2',7,7'-Tetrakis-(N,N-diphenylamino)-9,9'-spirobifluoren | |
| BAlq | 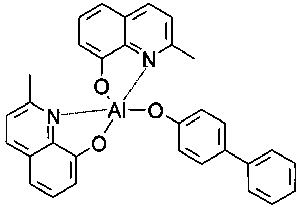 |
| Bis-(2-methyl-8-quinolinolato)-4-(phenyl-phenolato)-aluminium-(III) | |
| Ir(piq)₃ | 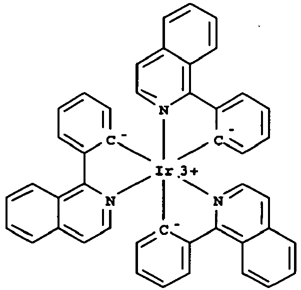 |
| Tris(1-phenylisoquinoline)iridium | |
| Bphen | 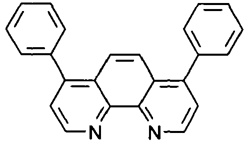 |
| 4,7-diphenyl-1,10-phenanthroline | |
| [Ru(t-butyl-trpy)₂]⁰ | 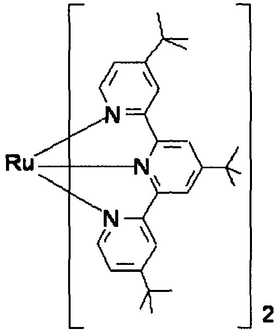 |
| AOB | 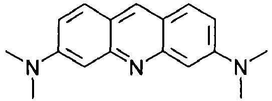 |
| Acridine orange base | |
| WPW | Tetrakis(1,2,3,3a,4,5,6,6a,7,8-decahydro-1,9,9b-triazaphenalenyl)ditungsten(II); |
| PTCDA | Perylene tetracarbonsäure dianhydrid |
| BEDT-TTF | Bisethylenedithiatetrathiafulvalene |
| TCNQ | Tetrazyano Chinodimethane |

## Patentansprüche

1. Organisches optoelektronisches Bauelement, mit:
- einer Grundelektrode (10),
- einer mit Durchbrüchen (40) versehenen Deckelektrode (30),
- einer Anordnung organischer Schichten (20), die zwischen der Grundelektrode (10) und der Deckelektrode (30) und in elektrischem Kontakt mit diesen gebildet ist und in welchem in einem lichtemittierenden Bereich (20b) beim Anlegen einer elektrischen Spannung an die Grundelektrode (10) und die Deckelektrode (30) Licht erzeugbar ist,
- einer Ladungsträgertransportschicht (20c), die unterhalb des lichtemittierenden Bereiches (20b) zwischen der Grundelektrode (10) und dem lichtemittierenden Bereich (20b) gebildet ist, und
- einer organischen Stromverteilungsschicht (20a), die sich auch in den Bereich der Durchbrüche (40) hinein erstreckt, die in elektrischem Kontakt mit der Deckelektrode (30) und dem lichtemittierenden Bereich (20b) ist und die zwischen der Deckelektrode (30) und dem lichtemittierenden Bereiches (20b) gebildet ist,
wobei die organische Stromverteilungsschicht (20a) direkt auf dem lichtcmitticrcnden Bereich (20b) angeordnet ist, **dadurch gekennzeichnet, dass** die organische Stromverteilungsschicht (20a) mit einer Schicht aus einem Ladungsträgertransportmaterial und einer hieran angrenzenden Schicht aus einem Dotandenmaterial gebildet ist, wobei die Grenzfläche zwischen der Schicht aus dem Ladungsträgertransportmaterial und der Schicht aus dem Dotandenmaterial als eine dotierte Grenzfläche mit einer die elektrische Leitfähigkeit erhöhenden Dotierung gebildet ist, derart, dass die organische Stromverteilungsschicht (20a) eine elektrische Leitfähigkeit von wenigstens 0.001 S/cm aufweist.

2. Bauelement nach Anspruch 1, **dadurch gekennzeichnet, dass** die organische Stromverteilungsschicht (20a) in Berührungskontakt mit der Deckelektrode (30) gebildet ist.

3. Bauelement nach Anspruch 1 oder 2, **dadurch gekennzeichnet, dass** die organische Stromverteilungsschicht (20a) mit einer elektrischen Leitfähigkeit von wenigstens 0.05 S/cm gebildet ist, bevorzugt mit einer elektrischen Leitfähigkeit von wenigstens 1 S/cm.

4. Bauelement nach einem der vorangehenden Ansprüche, **dadurch gekennzeichnet, dass** eine minimale Abmessung der Durchbrüche (40) wenigstens so groß ist wie eine Gesamthöhe der Anordnung organischer Schichten (20).

5. Bauelement nach einem der vorangehenden Ansprüche, **dadurch gekennzeichnet, dass** die Schicht aus dem Ladungsträgertransportmaterial der organischen Stromverteilungsschicht (20a) als eine elektrische Ladungsträger in Form von Löchern in Richtung der Schichtausdehnung transportierende Schicht gebildet ist, wenn die Deckelektrode (30) eine Anode ist.

6. Bauelement nach einem der Ansprüche 1 bis 4, **dadurch gekennzeichnet, dass** die Schicht aus dem Ladungsträgertransportmaterial der organischen Stromverteilungsschicht (20a) als eine elektrische Ladungsträger in Form von Elektronen in Richtung der Schichtausdehnung transportierende Schicht gebildet ist, wenn die Deckelektrode (30) eine Kathode ist.

7. Bauelement nach einem der vorangehenden Ansprüche, **dadurch gekennzeichnet, dass** die Schicht aus dem Ladungsträgertransportmaterial der organischen Stromverteilungsschicht (20a) als eine Fullerenschicht gebildet ist.

8. Bauelement nach einem der vorangehenden Ansprüche, **dadurch gekennzeichnet, dass** die organische Stromverteilungsschicht (20a) in Verbindung mit einem pn-Übergang aufweisend gebildet ist.

9. Bauelement nach einem der vorangehenden Ansprüche, **dadurch gekennzeichnet, dass** die organische Stromverteilungsschicht (20a) teilweise auf einer von der Anordnung organischer Schichten (20) abgewandten Seite der Deckelektrode (30) gebildet ist.

10. Verwendung eines organischen optoelektronischen Bauelementes nach einem der vorangehenden Ansprüche in einer Vorrichtung ausgewählt aus der folgenden Gruppe von Vorrichtungen: organische lichtemittierende Diode, Anzeigeeinrichtung wie Bildschirm oder Display und Beleuchtungseinrichtung.

## Claims

1. An organic optoelectronic component, with:
- a base electrode (10),
- a top electrode (30) provided with passages (40),
- an arrangement of organic layers (20) which is formed between the base electrode (10) and the top electrode (30) and makes electrical contact with said electrodes, and in which said component light can be generated in a light-emitting region (20b) by the application of a voltage to the base electrode (10) and top electrode (30),
- an electric charge-carrier transporting layer (20c), which is formed below the light-emitting region (20b) between the base electrode (10) and the light-emitting region (20b), and
- an organic current distribution layer (20a) that also extends into the region containing the passages (40), which said organic current distribution layer (20a) makes electrical contact with the top electrode (30) and the light-emitting region (20b) and is formed between the top electrode (30) and the light-emitting region (20b),
wherein the organic current distribution layer (20a) is arranged directly onto the light-emitting region (20b), **characterized in that** the organic current distribution layer (20a) is formed with a layer made of charge-carrier transport material and a layer of dopant material adjacent thereto, wherein the boundary surface between the layer made of charge-carrier transport material and the layer of dopant material is formed as a doped boundary surface with a doping increasing electric conductivity, such that the organic current distribution layer (20a) has an electric conductivity of at least 0.001 S/cm.

2. The component according to claim 1, **characterized in that** the organic current distribution layer (20a) is formed in physical contact with the top electrode (30).

3. The component according to claim 1 or 2, **characterized in that** the organic current distribution layer (20a) is formed so that it has an electric conductivity of at least 0.05 S/cm, preferably with an electric conductivity of at least 1 S/cm.

4. The component according to any of the preceding claims, **characterized in that** a minimal dimension of the passages (40) is at least as large as a total height of the arrangement of organic layers (20).

5. The component according to any of the preceding claims, **characterized in that** the layer made of charge-carrier transport material of the organic current distribution layer (20a) is formed as a layer transporting electric charges in the form of holes in the direction of the extension of the layer, when the top electrode (30) is an anode.

6. The component according to any of the claims 1 to 4, **characterized in that** the layer made of charge-carrier transport material of the organic current distribution layer (20a) is formed as a layer transporting electric charges in the form of electrons in the direction of the extension of the layer, when the top electrode (30) is a cathode.

7. The component according to any of the preceding claims, **characterized in that** the layer made of charge-carrier transport material of the organic current distribution layer (20a) is formed as a fullerene layer.

8. The component according to any of the preceding claims, **characterized in that** the organic current distribution layer (20a) is formed in connection with a p-n-junction.

9. The component according to any of the preceding claims, **characterized in that** the organic current distribution layer (20a) is formed partly on the side of the top electrode (30) facing away from the arrangement of organic layers (20).

10. Application of an organic optoelectronic component according to any of the preceding claims in a device selected from the following group of devices: organic light-emitting diode, display device such as a monitor or a display, and illumination device.

## Revendications

1. Composant optoélectronique organique, avec :
- une électrode de base (10),
- une électrode de recouvrement (30), munie d'ajours (40) ;
- un agencement de couches organiques (20), qui est formé entre l'électrode de base (10) et l'électrode de recouvrement (30) et en contact électrique avec ces dernières et dans lequel, dans une zone (20b) émettrice de lumière, lors de l'application d'une tension électrique sur l'électrode de base (10) et l'électrode de recouvrement (30), de la lumière peut être générée,
- une couche de transport d'un porteur de charge (20c), qui est formée en-dessous de la zone (20b) émettrice de lumière, entre l'électrode de base (10) et la zone (20b) émettrice de lumière et
- une couche organique distributrice de courant (20a), qui s'étend également à l'intérieur de la zone des ajours (40), qui est en contact électrique avec l'électrode de recouvrement (30) et la zone (20b) émettrice de lumière et qui est formée entre l'électrode de recouvrement (30) et la zone (20b) émettrice de lumière,
la couche organique distributrice de courant (20a) étant placée directement sur la zone (20b) émettrice de lumière, **caractérisé en ce que** la couche organique distributrice de courant(20a) est formée d'une couche en une matière transporteuse d'un porteur de charges et une couche qui y est adjacente en une matière dopante, la surface limite entre la couche en matière transporteuse d'un porteur de charge et la couche en matière dopante étant formée en tant qu'une surface limite dopée avec un dopage augmentant la conductibilité électrique, de telle sorte que la couche organique distributrice de courant (20a) fasse preuve d'une conductibilité d'au moins 0.001 S/cm.

2. Composant selon la revendication 1, **caractérisé en ce que** la couche organique distributrice de courant (20a) est formée en étant en contact mécanique avec l'électrode de recouvrement (30).

3. Composant selon la revendication 1 ou la revendication 2, **caractérisé en ce que** la couche organique distributrice de courant (20a) est formée avec une conductibilité électrique d'au moins 0.05 S/cm, de préférence avec une conductibilité électrique d'au moins 1 S/cm.

4. Composant selon l'une quelconque des revendications précédentes, **caractérisé en ce qu'**une dimension minimale des ajours (40) est au moins aussi grande qu'une hauteur totale de l'agencement de couches organiques (20).

5. Composant selon l'une quelconque des revendications précédentes, **caractérisé en ce que** la couche en la matière transporteuse de porteurs de charges de la couche organique distributrice de courant (20a) est formée en tant qu'une couche transportant des porteurs de charges électriques sous la forme de trous dans la direction de l'extension de la couche, si l'électrode de recouvrement (30) est une anode.

6. Composant selon l'une quelconque des revendications 1 à 4, **caractérisé en ce que** la couche en une matière transporteuse de porteurs de charges de la couche organique distributrice de courant (20a) est formée tant qu'une couche transportant des porteurs de charges électriques sous la forme d'électrons dans la direction de l'extension de la couche, si l'électrode de recouvrement (30) est une cathode.

7. Composant selon l'une quelconque des revendications précédentes, **caractérisé en ce que** la couche en une matière transporteuse de porteurs de charges de la couche organique distributrice de courant (20a) est formée en tant qu'une couche de fullerène.

8. Composant selon l'une quelconque des revendications précédentes, **caractérisé en ce que** la couche organique distributrice de courant (20a) est formée en liaison en présentant avec une jonction p-n.

9. Composant selon l'une quelconque des revendications précédentes, **caractérisé en ce que** la couche organique distributrice de courant (20a) est formée en partie sur une face de l'électrode de recouvrement (30) qui est opposée à l'agencement couches organiques (20).

10. Utilisation d'un composant optoélectronique organique selon l'une quelconque des revendications précédentes, dans un dispositif choisi dans le groupe suivant de dispositifs : diode électroluminescente organique, système d'affichage, tel qu'écran ou visualiseur et système d'éclairage.
